# EUROPÄISCHE PATENTANMELDUNG

(11) **EP 1 291 901 A2**
(43) Veröffentlichungstag der Anmeldung: **12.03.2003**
(21) Anmeldenummer: 02019578.0
(22) Anmeldetag: 02.09.2002
(51) Int. Cl.: H01L 21/00

(54) **Vorrichtung mit einem Greifer zur Handhabung von Platten**

(30) Priorität: 10.09.2001 DE 10144409
(71) Anmelder: Infineon Technologies AG, 81669 München (DE)
(72) Erfinder: Binder, Alfred, 9500 Landskron (AT); Kroupa, Gerhard, 9500 Villach (AT); Matschitsch, Martin, 9181 Feistritz i. Ros. (AT); Unterweger, Josef, 9520 Annenheim (AT)
(74) Vertreter: Kindermann, Peter

(57) **Zusammenfassung**

Die Erfindung betrifft eine Vorrichtung mit einem Greifer (1) zur Handhabung von Platten, insbesondere zum Handhaben von dünnen Wafern (W), mit einer Aufnahmeplatte (3), welche Düsenbohrungen (4) zum Erzeugen eines hydrodynamischen Unterdrucks aufweist, wobei die Aufnahmeplatte (3) über mechanische Anschläge (5, 6) verfügt, die am Umfangsbereich (7) der zu handhabenden Platte (W) angreifen und diese in ihrer Position fixieren.

## Beschreibung

Die vorliegende Erfindung bezieht sich auf eine Vorrichtung, mit einem Greifer zur Handhabung von Platten, insbesondere zum Handhaben von dünnen Wafern.

Halbleiterscheiben oder -wafer sind bekanntlich sehr dünn und weisen bei einem Durchmesser in der Größenordnung 2 bis 8 Zoll Scheibendicken auf, die in der Größenordnung von einigen 10 bis einigen 100 µm liegen. Solche Halbleiterscheiben werden bisher zumeist manuell bzw. mit einem manuell bedienbaren Handlingsystem von einem ersten Prozessierungsort zu einem zweiten Prozessierungsort gebracht.

Bei den unterschiedlichen Prozessschritten, beispielsweise beim Dünnschleifen der Waferscheiben entstehen oft verbogene Halbleiterscheiben, die sowohl konkave als auch konvexe Krümmungen aufweisen können. Diese Halbleiterscheiben können dann durch ein automatisches Handlingsystem nicht mehr problemfrei gehandhabt werden. Bisher werden dünne Wafer daher manuell in den verschiedenen Materialträgern Ent- und Beladen. Dies geschieht oft manuell mit Hilfe einer sogenannten Pinzette als Handlinghilfe, mit der die Halbleiterscheiben aus einem entsprechenden Behälter entnommen und zur weiteren Prozessierung beispielweise in ein Quarzboot, - einem Behälter aus Quarz -, gebracht werden. Der Einsatz einer Pinzette ist aber nicht unproblematisch, da dieser zu teilweisen Beschädigungen, wie der Entstehung von Haarrissen und damit zu einem Ausfall von Chips in dem entsprechenden Bereich der Halbleiterscheibe führen kann. Obwohl also die Be- und Entladevorgänge nur von speziell geschultem Personal durchgeführt werden ist die Bruchrate beim manuellen Handling entsprechend hoch.

Bekannte Handlinghilfen in Form von sogenannten pneumatischen Pinzetten sind beispielsweise aus der DE 199 48 572 A1 bekannt. Die dort beschriebene Vorrichtung verfügt über eine Düsenplatte, welche einen hydrodynamischen Unterdruck zwischen der Düsenplatte und dem zu handelnden Wafer erzeugt, und die mit einer Saugbohrung zum zusätzlichen Ansaugen der Halbleiterplatte ausgestattet ist. Dort wird also mit Hilfe der Düsenplatte der Bernoulli-Effekt ausgenutzt und mit der zusätzlichen Saugbohrung die Haltekraft aufgebaut. Die zu handhabende Halbleiterscheibe wird mit einer derartigen pneumatischen Pinzette zwar berührungslos gehalten, aber die Handhabung muss weiterhin manuell erfolgen, da keine Bezugspositionen für die zu handhabende Halbleiterscheibe vorhanden sind. Derartige Bezugspositionen, beispielsweise Zentrierungen sind aber für einen automatisierten Ablauf der Handhabungsvorgänge Voraussetzung.

Das automatische Entnehmen und Einfügen von mechanisch wenig belastbaren Wafern aus oder in Materialträgern (Kunststoffhorden, Quarzboote, o. a. Behälter) müsste zur Vermeidung von Beschädigungen ohne Kantenkontakt der Wafer erfolgen.

Da jedoch die Voraussetzungen dafür nicht gegeben waren, wurde bisher auf automatisierte Prozesse verzichtet, weil - wie bereits oben beschrieben, - die Wafer nicht zentriert in den Materialträgern abgelegt sind und damit die kontrollierte Entnahme der Wafer aus einer reproduzierbaren Bezugsposition nicht gewährleistet ist.

Die höchst sensiblen Bewegungsabläufe der einzelnen manuell ausgeführten Vorgänge können also nur unter großem persönlichem Einsatz des Operators durchgeführt werden. Entsprechend hoch ist auch der zeitliche Aufwand für das manuelle Dünnwaferhandling.

Das vorbeschriebene sensible Handling erfolgt demgemäss bisher ausschließlich durch manuelle Ent- oder Bestückung an den entsprechenden Materialträgern. Nicht geeignet für das Hordenhandling sind beispielsweise auch Greifer mit Zentrierstiften, da die geringe Bauhöhe der Schächte (Schlitze) in den Aufbewahrungsbehältern keine räumlich erhabenen Stifte, auch "Zentrierpins" genannt, erlaubt. Die Bauhöhe, d. h. die Rasterabstände in den Horden sind genormt, und für Greifer mit hervorstehenden Vorrichtungsbauteilen ungeeignet.

Es ist daher Aufgabe der vorliegenden Erfindung, eine Vorrichtung zum Handling von Halbleiterscheiben zu schaffen, die ein sicheres Transportieren und Handhaben der Halbleiterscheiben, wie beispielsweise eine Horden- und/oder Quarzbootbestückung, erlaubt, und automatische Be- und Entladevorgänge ermöglicht.

Diese Aufgabe wird von einer Vorrichtung mit den Merkmalen des Anspruches 1 gelöst. Vorteilhafte Ausgestaltungen der erfindungsgemäßen Vorrichtung entnimmt man den abhängigen Ansprüchen.

Die besonderen Vorteile der erfindungsgemäßen Vorrichtung liegen darin, dass der zu handhabende Wafer durch die Anschläge in der Vorrichtung zentriert ist und somit eine reproduzierbare Bezugsposition einnimmt, und dass ferner die Anschläge die Oberkante der durch den Bernoulli-Effekt gehaltenen Waferscheibe nicht überragen. Ferner ist von Vorteil, dass die Anschläge V-förmig angeordnet sind und so einen Zentrierbund für die Waferscheibe bilden, die eine Anschlagfläche oder dergleichen aufweist, welche mit einem Justieransatz derart korrespondiert, dass eine Verdrehsicherung gebildet wird, die die Waferscheibe in einer selbstzentrierenden reproduzierbaren Bezugsposition hält.

Mit Hilfe eines Ausführungsbeispiels soll die Erfindung anhand der Zeichnung noch näher erläutert werden.

Es zeigt:
Figur 1 einen Dünnwafer-Greifer und
Figur 2 einen Dünnwafer-Greifer mit gehaltenem Dünnwafer.

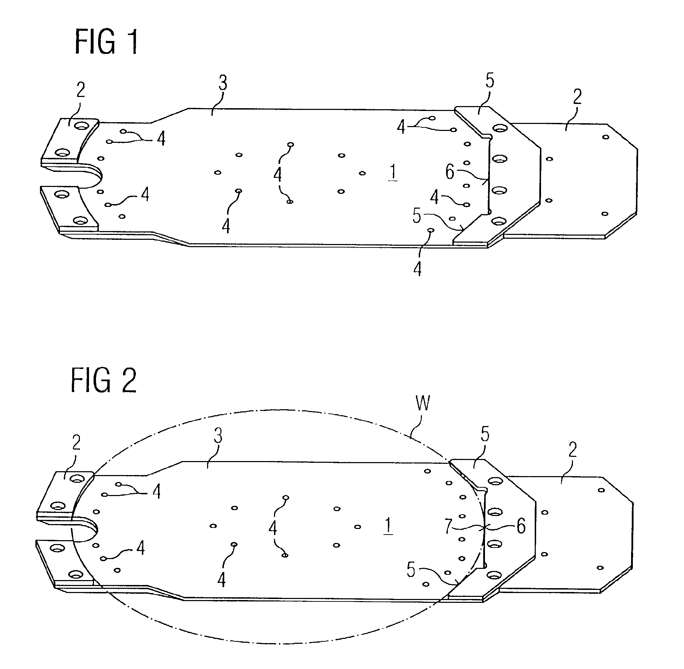

In Figur 1 ist ein Dünnwafer-Greifer ausgebildeter Greifer 1 zum Handhaben von Waferscheiben W gezeigt. Die zu handhabende Waferscheibe W ist erst in Figur 2 bildlich dargestellt. Der Dünnwafer-Greifer 1 verfügt über eine Greiferhalterung 2 mittels welcher er an einem nicht dargestellten Roboterarm befestigt werden kann. Mit dem Bezugszeichen 3 ist eine Aufnahmeplatte bezeichnet, die als aktive, sogenannte "Bernoulli-Fläche" ausgebildet ist, in welcher sich eine Vielzahl von Düsenbohrungen 4 befindet. Die geometrische Anordnung der Düsenbohrungen 4 richtet sich nach den Halbleiterscheiben (Waferscheiben W), die zu handhaben sind. Es ist vom Fachmann wenigstens eine Standardanordnung vorzusehen. Die Düsenbohrungen 4 sind dabei so ausgerichtet, dass sie vom Flächenschwerpunkt der Bernoulli-Fläche der Aufnahmeplatte 3 aus unter einem bestimmten Winkel nach außen gerichtet sind. Dadurch ist gewährleistet, dass das aus den Düsenbohrungen 4 ausströmende Gas vom Zentrum aus nach außen hin strömt. Auf diese Weise wird der sogenannte "Bernoulli-Effekt" erzeugt, welcher bewirkt, dass vom Zentrum der Aufnahmeplatte (Bernoulli-Fläche) 3 aus ein hydrodynamischer Unterdruck zwischen der Aufnahmeplatte 3 und der aufzunehmenden Waferscheibe W entsteht. Durch diesen hydrodynamischen Unterdruck "haftet" die Waferscheibe W berührungslos an dem Dünnwafer-Greifer 1 und kann sicher und zuverlässig aus jeder Position geholt und in jede Position gebracht werden. Da auf zusätzliche "pneumatische Halterungen", beispielsweise auf das Ansaugen mittels Vakuum verzichtet wird, ist es auch ohne Gefahr für die zu haltende Halbleiterscheibe (Waferscheibe W) zulässig, sie von beiden Oberflächenseite her zu handhaben. Aus Sicherheitsgründen ist es nämlich unzulässig, eine Halbleiterscheibe auf der Oberflächeseite anzugreifen, auf der sich eine Halbleiterstruktur befindet, oder auf der eine Halbleiterstruktur angeordnet werden soll. Dieses Verbot gilt sicherheitshalber auch für Handhabung mittels Vakuumansaugung.

Der Dünnwafer-Greifer 1 ist in der Nähe seines einen Endes mit Anschlägen 5 versehen, die V-förmig angeordnet sind und in ihrer Höhe so bemessen sind, dass sie eine "schwebende" Waferscheibe W nicht wesentlich überragen.

Die V-förmig verlaufenden Anschläge 5 nehmen in ihrer Spitze einen Justieransatz 6 auf, welcher mit wenigstens einer Anschlagfläche 7 an der zu handhabenden Waferscheibe W korrespondiert.

Durch die V-förmigen Anschläge 5, welche die Waferscheibe W zwischen ihren Schenkeln selbstzentrierend aufnehmen, ist die Waferscheibe W immer sicher zentriert und durch den Justieransatz 6, der mit der Anschlagfläche 7 der Waferscheibe W korrespondiert, ist eine Verdrehsicherung für die Lage der Waferscheibe W gegenüber dem Dünnwafer-Greifer 1 geschaffen. Durch diese beiden Maßnahmen ist der Waferscheibe W eine reproduzierbare Bezugsposition aufgezwungen, wodurch ein automatisches Waferhandling möglich wird. Der Dünnwafer-Greifer 1 kann an einem nicht dargestellten Roboterarm angeordnet sein und ermöglicht durch seine geringe Bauhöhe einen Zugriff zu dem Aufbewahrungsort der Waferscheiben W sowohl von unten als auch von oben, bezogen auf die Lage der Waferscheibe W in einem Materialträger.

Die genormten Rasterabstände in einem Materialträger, beispielsweise einer Horde können durch die geringe Bauhöhe des Dünnwafer-Greifers 1 ausgenützt werden. Innerhalb einer solchen Kassette (Materialträger, Horde, Quarzboot) erfolgt eine Selbstzentrierung der Waferscheibe W auf dem Dünnwafer-Greifer 1, wenn dieser automatisch in den Materialträger eingefahren wird und eine Waferscheibe W aufnimmt. Bei dem nachfolgenden Handling der Waferscheibe W während irgendwelcher Prozesse bleibt die Orientierung der Waferscheibe W auf dem Dünnwafer-Greifer 1 immer erhalten.

Die Besonderheiten dieses Greifers 1 sind zusammengefasst:
die Selbstzentrierfunktion, die eine Waferscheibe W beim Erfassen selbsttätig ausrichtet. Ferner wird zur Aufnahme, Fixierung und Zentrierung der Waferscheibe W ausschließlich das Bernoulliprinzip (Bernoulli-Effekt) verwendet.
Der Greifer 1 hat die Eigenschaft, die Waferscheibe W, im speziellen Fall -die Dünnwaferscheibe - ohne Beschädigung:
- in der Horde (Trägerkassette)zu erfassen
- zu zentrieren
- und zu entnehmen,
- auch bei schnellen Bewegungen in drei Dimensionen zu halten,
- und an andere Wafer Aufnahmevorrichtungen (Quarzboot o. ä.) zentriert zu übergeben.
- Zudem besitzt er die Eigenschaft leicht verbogene Wafer zu Planarisieren und ist daher besonders für die Handhabung dünner Wafer geeignet.
- Die Vorrichtung ist reinraumtauglich.

Der vorliegende Dünnwafer-Greifer 1 wurde für diese speziellen Aufgaben, welche sich der in der Einleitung genannten Aufgabe unterordnen, geschaffen, ist aber darüber hinaus allgemein einsetzbar. Es können nicht nur Wafer W sondern alle ähnlich geformten, annähernd ebenen Gegenstände, deren Gewicht und Abmessungen in der gleichen Größenordnung liegen gehandhabt werden. Weder die Scheibenform der Wafer W, noch das Material, oder die Oberflächenbeschaffenheit spielen beim Greifen eine Rolle. Die einzige Einschränkung ist eine nicht zu starke Verspannung des Gegenstandes, weil die Planarisierungskraft des Greifers 1 begrenzt ist. Der Greifer 1 ist so geformt, dass mit ihm Wafer W aus Horden entnommen und in ein Quarzboot abgelegt werden können. Aber auch diese Geometrie stellt keine Einschränkung für andere Anwendungen dar.

## Patentansprüche

1. Vorrichtung mit einem Greifer zur Handhabung von Platten, insbesondere zum Handhaben von dünnen Wafern, mit einer Aufnahmeplatte, welche Düsenbohrungen zum Erzeugen eines hydrodynamischen Unterdrucks aufweist, **dadurch gekennzeichnet, dass** die Aufnahmeplatte (3) über mechanische Anschläge (5, 6) verfügt, die am Umfangsbereich (7) der zu handhabenden Platte (W) angreifen.

2. Vorrichtung nach Anspruch 1, **dadurch gekennzeichnet, dass** die Anschläge (5, 6) sich im Wesentlichen bis zur Oberkante der durch den hydrodynamischen Druck schwebend gehaltenen Platte (W) erstrecken und diese nur unwesentlich überragen.

3. Vorrichtung nach Anspruch 1, **dadurch gekennzeichnet, dass** die Anschläge (5) V-förmig ausgebildet sind, am Umfang der Platte (W) tangential angreifen und so einen Zentrierbund für die Platte (W) bilden.

4. Vorrichtung nach Anspruch 1, **dadurch gekennzeichnet, dass** die Anschläge (5, 6) über einen Justieransatz (6) verfügen, der mit einer Anschlagfläche (7) an der zu handhabenden Platte (W) korrespondiert und eine Verdrehsicherung für diese bildet.

5. Vorrichtung nach Anspruch 1, **dadurch gekennzeichnet, dass** die Düsenbohrungen (4) eine vom Zentrum der Aufnahmeplatte (3) wegweisende Richtung aufweisen.

6. Vorrichtung nach Anspruch 1 und 5, **dadurch gekennzeichnet, dass** die Aufnahmeplatte (3) mittels durch die Düsenbohrungen (4) strömendem Gas einen hydrodynamischen Unterdruck, den sogenannten Bernoulli-Effekt erzeugt.

7. Vorrichtung nach Anspruch 1, **dadurch gekennzeichnet, dass** die zu handhabenden Platten Waferscheiben (W), insbesondere dünne Wafer (W) sind.

8. Vorrichtung nach Anspruch 1, **dadurch gekennzeichnet, dass** der Greifer (1) als Dünnwafer-Greifer ausgebildet und Endeffektor eines Roboters ist.

9. Vorrichtung nach Anspruch 1, **dadurch gekennzeichnet, dass** der Greifer (1) reinraumtauglich ausgebildet ist.
